# EUROPEAN PATENT SPECIFICATION

(11) **EP 0 652 303 B1**
(45) Date of publication and mention of the grant of the patent: **10.09.1997**
(21) Application number: 94308158.8
(22) Date of filing: 04.11.1994
(51) Int. Cl.: C23C 14/56, C23C 14/24

(54) **Evaporator for vacuum web coating**
Vakuumverdampfer zum Beschichten einer Bahn
Evaporateur pour le revêtement sous vide d'une bande

(30) Priority: 09.11.1993 GB 9323033
(43) Date of publication of application: 10.05.1995
(73) Proprietor: IMPERIAL CHEMICAL INDUSTRIES PLC, London SW1P 3JF (GB)
(72) Inventor: Baxter, Ian Kenneth, Rochdale, Lancs OL11 5PJ (GB); Watkins, Keith, Rochdale, Lancs OL11 5PJ (GB); Bishop, Charles Arthur, Middlesburgh, Cleveland TS8 0A (GB); McGee, David Charles, Fogelsville, PA 18051 (US)
(74) Representative: Ede, Eric

(56) References cited:
- DE-C- 4 128 382
- US-A- 4 094 269
- PATENT ABSTRACTS OF JAPAN vol. 012, no. 110 (C-486) 8 April 1988 & JP-A-62 235 466 (CANON INC) 15 October 1987
- PATENT ABSTRACTS OF JAPAN vol. 011, no. 035 (P-542) 3 February 1987 & JP-A-61 204 639 (FUJI ELECTRIC CO LTD) 10 September 1986
- PATENT ABSTRACTS OF JAPAN vol. 013, no. 221 (C-598) 23 May 1989 & JP-A-01 031 964 (MITSUI PETROCHEM IND LTD) 2 February 1989

## Description

This invention relates to an evaporator suitable for vaporising coating material in vacuum web coating processes, to apparatus for web coating and to a process of web coating using the evaporator.

In vapour deposition processes coating material is vaporised in a heated crucible and the vapour is condensed on a surface of the web to be coated, the web generally being a large continuous web which is continuously moved through a vapour deposition zone by winding gear. The deposition zone is usually provided by a chilled metal surface and generally is a rotating cold drum over which the web is advanced. In order to avoid contaminants the coating process is carried out in a vacuum chamber at high vacuum wherein the pressure is generally in the range 1.33-1.33 x 10⁻² pascals (10⁻² - 10⁻⁴ Torr) and the process is accordingly termed vacuum web coating. The crucible is generally contained in an evaporation retort having an elongated outlet nozzle profiled as a slit disposed across the web, through which nozzle the vaporised material is transferred to the web surface where it condenses as a thin film coating. Using appropriate transport systems one or both sides of a web may be coated with one or more coats of material. The thickness and uniformity of the film can be accurately maintained by controlling the rate of evaporation of the coating material and the time of exposure of the web substrate to the vapour emerging from the nozzle, the exposure time being generally controlled by controlling the travel speed of the web relative to the nozzle. Web coating by vapour deposition has been described in the book "Web Processing and Converting Technology (Van Nostrand Reinhold Company - 1984) - Chapter 11 entitled "High - vacuum roll coating" by Ernst K Hartwig". Using this process, well defined film coatings of metals, alloys or other materials having thicknesses typically of less than 0.1µm(micron) can be applied to substrates such as paper or plastic as thin as 1.0µm (micron).

In the usual apparatus the deposition zone is provided at the surface of a chilled rotating drum through which cooling fluid, usually at about -30°C is continuously circulated. The web is advanced in a continuous manner around the chilled drum from a pay-off roll to a take-up roll. Either or both of these web-carrying rolls may be inside the vacuum chamber and in this case, when the web requires to be replaced or coated material has to be removed, the process must be temporarily stopped. Additional stoppages are required for replenishment of the coating material in the crucible or for the replacement or maintenance of the crucible or the crucible heating means. Any stoppage necessitates cooling of the retort and its contents and opening at least part of the vacuum chamber with consequent long interruption of the production.

JP-A-62235466 discloses an evaporator wherein high melting point material is heated and evaporated in a crucible to which gas in introduced, the vapour being thereby ejected through a nozzle and deposited on a substrate. The evaporator is not designed for stopping of the evaporation or rapid cooling.

An object of this invention is to provide an evaporator in which the evaporation can be rapidly quenched and which, optionally, can be rapidly cooled and reheated thereby reducing the duration ofthe required stoppages.

In accordance with the invention an evaporator for vacuum web coating comprises evaporation means for vaporising coating material to be deposited on a web substrate, said evaporation means having vapour outlet means comprising at least one outlet nozzle through which vapour can be conveyed and deposited on a web substrate at a deposition zone, and supply means whereby when the process must be stopped inert gas is fed to the evaporation means to quench the evaporation of the material and optionally to cool the evaporation means.

The term 'inert gas' is used herein to mean any gas which does not react with the coating material to an extent which would impair the properties of the coating.

Introduction of inert gas around the material being vaporised at a pressure higher than the evaporation vapour pressure will instantly quench the evaporation and deposition of coating material so that the web advance may be halted to allow coated material to be removed and/or a supply of web substrate to be put in place at the end of a production cycle. Additionally the gas supply means may be arranged to feed sufficient gas to accelerate cooling of the evaporation means and its contents.

Thus, after quenching the evaporation, sufficient gas can be supplied to cool the evaporation means and the coating material to a safe temperature at which replenishment of coating material or any other necessary work on the evaporation means may be safely carried out. For increased cooling efficiency the gas supply means is advantageously one which recirculates the inert gas through gas refrigeration means and/or supplies the inert gas under conditions of turbulent flow.

The evaporation means preferably comprises at least one retort, each retort having at least on vapour outlet nozzle and being sealed except for the vapour outlet nozzle or nozzles. Each retort conveniently contains at least one crucible in which material is heated to its vaporisation temperature. Heating means for heating the crucible may be disposed outside or inside the retort. When the evaporation means comprises only one retort, the heating means is preferably enclosed within the retort. However, in evaporation means comprising two or more retorts a common heating means may be used to vaporise coating material in at least two of the retorts and this may conveniently be outside the retorts. One convenient heating means is an electrically heated radiation source. Preferably at least one retort has a sealed lid in which at least one outlet means is located, the lid being removable to allow recharging of the evaporation crucible as required and any replacement of the crucible or heating means. In order to facilitate rapid heating and cooling any retort and crucible preferably has low thermal capacity and the retort is preferably encased in a radiation shield which may comprise, for example, ceramic material or refractory metal such as tungsten, molybdenum or tantalum.

The vapour outlet means may comprise a single nozzle which in operation is advantageously shaped as an elongated slot disposed transversely to the web to be coated. However, the preferred vapour outlet means comprises a plurality of separately spaced outlet nozzles operatively disposed to convey vapour to predetermined portions of a deposition zone extending along a path of an advancing web substrate.

The nozzles may be of any convenient length and may be disposed in varying array to eject vapour to any desired position of the deposition zone. Likewise the profile, area, spacing and direction of the nozzle outlets may be varied as desired. Thus the outlet profiles may comprise circular, rectangular or star-shaped apertures which may be distributed in line or staggered over the area
of the deposition zone. A further especially convenient nozzle profile is a continuous slot preferably extending over the width of the web to be coated. One advantageous nozzle outlet arrangement comprises a plurality of linear slots disposed transversely to the web substrate path to deliver vapour to positions of the deposition zone disposed sequentially along a web substrate path.

The nozzle outlets may in some cases lie in the same plane but in other cases the outlets may be non-planar. Thus when the deposition zone is at a surface portion of a rotable drum it is advantageous for the nozzle ends to be disposed on an arcuate surface around, but spaced from, the curved surface of the drum.

The use of the inert gas to quench the evaporation enables the use of finer vapour outlet nozzles by reducing the tendency for nozzle blockage to occur due to continuing evaporation after a process stoppage.

The invention also includes web coating apparatus comprising the aforedescribed evaporator within a vacuum chamber and in operative combination with web holding means for maintaining a web substrate in a deposition zone, whereat vapour generated by the evaporator is in operation deposited on the web substrate.

Accordingly, from another aspect, the invention consists in apparatus for vacuum web coating comprising a vacuum chamber containing at least one deposition zone; web holding means for maintaining a web substrate in said deposition zone; and evaporation means for vaporising material to be deposited on the web substrate, said evaporation means having vapour outlet means comprising at least one outlet nozzle through which vapour is conveyed and deposited on the said web substrate at the said deposition zone; and said apparatus further comprising supply means whereby when the process must be stopped inert gas is fed to the evaporation means to quench the evaporation of material therefrom and, optionally to cool the evaporation means.

The means for supplying the inert gas preferably comprises one or more gas-conveying conduits leading into the vacuum chamber from a source of inert gas located either inside or outside the chamber. The gas conveying conduit may be arranged to convey gas to a portion of the vacuum chamber which is in communication with the vapour outlet means so that quenching gas will in operation be back-fed through the vapour outlet means to the material by the evaporation means . However, it is preferred that at least one inert gas conduit should be arranged to feed gas directly from the gas source to the coating material in the evaporation means.

The web holding means preferably comprises a web transport system for continuously advancing a web substrate through the deposition zone and the deposition zone is advantageously provided by a chilled metal surface, preferably the surface of a rotable drum over which the web substrate is trained.

From a still further aspect the invention consists in a method of coating a web substrate using the aforedescribed apparatus.

Accordingly the invention includes a process of coating a web substrate in a vacuum which comprises maintaining the web substrate in a chilled deposition zone; vaporising a material to be deposited on the substrate;
conveying the generated vapour to the surface of the substrate at the said deposition zone; condensing the vapour as a coating on the substrate; and when the process must be stopped quenching the evaporation of material by introducing inert gas around the material being vaporised at a pressure higher than the evaporation vapour pressure of the material.

Sufficient gas may be introduced to cool the residual unvaporised material and any apparatus for heating or containing the material in order to allow the material or apparatus to be renewed. For this purpose it is advantageous to recirculate the inert gas through refrigeration means and/or to introduce the inert gas under turbulent conditions.

The inert gas conveniently comprises Argon, Helium, Nitrogen or a mixture of two or more thereof.

By using the inert gas for quenching and cooling in accordance with this invention the stoppage times for removal of a supply of coated product from a typical coating apparatus will be reduced from about 6-8 hours typically required for conventional apparatus to periods as low as 20 minutes.

The invention is further illustrated by the embodiments which are described by way of Example with reference to the accompanying diagrammatical drawings wherein
Fig. 1 shows in cross-section, a web coating apparatus ofthe invention arranged for single sided coating;
Fig. 2 shows in cross-section, a further web coating apparatus arranged for coating both sides of a web;
Fig. 3 is an elevation in section of an evaporator for use in web coating apparatus.
Fig. 4 is a cross-section on the line IV - IV of Figs. 3 and additionally showing the configuration of a web cooling drum;
Fig. 5 is a fragmentary sectional view of an alternative orientation of the apparatus units of Fig. 1;
Figs. 6-9 are fragmentary sectional views showing alternative modifications of nozzle arrays for the apparatus of Fig. 1;
Figs 10 and 11 are fragmentary perspective views of further alternative nozzle arrays for the apparatus of Fig. 1.

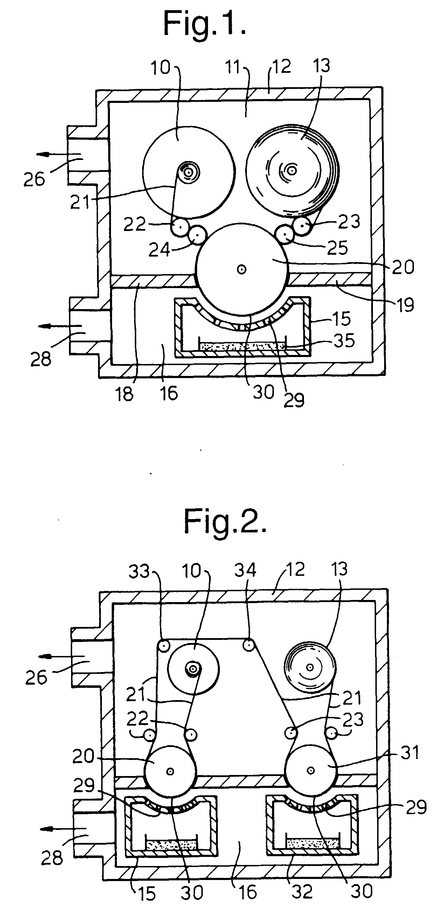

In the apparatus shown in Fig. 1 a web pay-off roll 10 and a web take-up roll 13 are contained in a compartment 11 of a vacuum chamber 12, and an evaporator 15 is located in a compartment 16 of chamber 12. The compartments 11 and 16 are separated by baffles 18 and 19 which extend inwardly from the inner wall of chamber 12 to a portion adjacent to a chilled drum 20. Web substrate 21 to be coated is advanced in a continuous manner from pay-off roll 10 over the curved surface of chilled drum 20 to take-up roll 13. Between the roll 10 and drum 20, and between roll 13 and drum 20 there are tensioning rolls 22 and 23 and guide rolls 24 and 25. A small clearance between the baffles 18 and 19 and the drum 20 allows free passage of the web substrate, but is sufficiently narrow to allow the pressure in the compartments 11 and 16 to be different during the deposition process and thereby prevent the vapour from reaching the web transport system. The compartments 11 and 16 can be evacuated through ports 26 and 28 respectively. The evaporator 15 is provided with five outlet nozzles 29, which are in the form of slots transverse to the substrate 21 and arranged sequentially around a deposition zone 30 on drum 20 in the direction of the substrate advance, the nozzles terminating on an arcuate surface substantially parallel to the curved surface of drum 20.

In operation the drum 20 is chilled by circulating cooling fluid and is rotated in synchronism with the pay-off roll 10 and take-up roll 13. The substrate 21 is fed over the surface of drum 20 and cooled before reaching the deposition zone 30 on drum 20 where vapour from the evaporator 15 is deposited on the substrate surface and adheres to the surface as a uniform coating.

The arrangement shown in Fig. 2 contains two chilled drums 20 and 31 and two evaporators 15 and 32 and additional guide rolls 33 and 34 are arranged so that the opposite sides of the substrate are respectively coated by the evaporators.

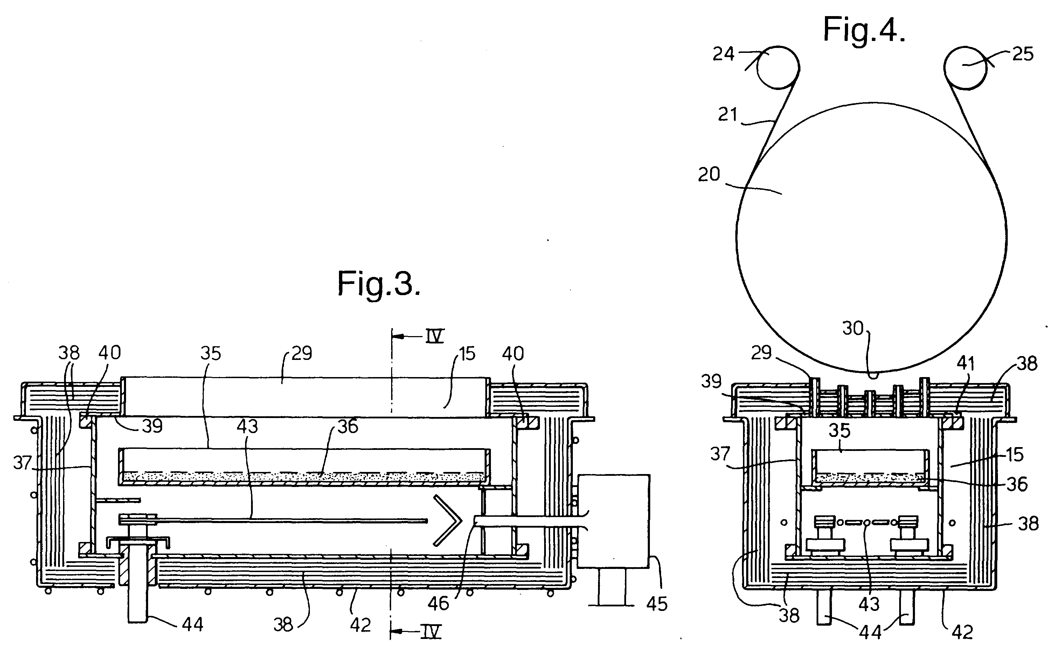

An evaporator 15 is shown in detail in Figs. 3 and 4. Fig. 4 also shows the relative positions of the nozzles 29 and the web substrate 21 at the deposition zone 30. The evaporator 15 comprises a crucible 35 in which the material 36 to be deposited on the substrate 21 is contained and evaporated. The crucible is encased in a retort 37 which in turn is encased in multiple layers of radiation shielding 38, the shielding 38 being backed by a fluid cooled shield 42 over the sides and bottom of the retort 37. The retort 37 has a lid 39 which is sealed to the body of the retort by a seal 40 and firmly held in position by clamps 41. Lid 39 is provided with spaced outlet nozzles 29, in the form of linear slots extending through the shielding 38 and terminating on an arcuate surface having a curvature roughly conforming to the curvature of the chilled drum 20 when viewed in cross-section as shown in Fig. 4. The nozzles 29 extend across the width of the web substrate 21 and are disposed sequentially in the direction of travel of the web 21. The retort 37 further contains a heating element 43 having power connecting leads 44 extending through and sealed into the bottom of the retort 37. A manifold 45 located outside the retort and connected to a source of inert gas (not shown) has one or more nozzles 46 extending through and sealed into the side of the retort 37.

In use, chamber 12 is evacuated, the web substrate 21 is continuously advanced, the material 36 is heated and evaporated and the vapour is emitted from the ends of the nozzles 29 to impinge on the moving substrate at the deposition zone 30 where is condenses on the substrate. The vapour is deposited sequentially from each nozzle 29 at any given transverse linear position on the substrate so that the film of condensed material is deposited progressively, allowing the structure and uniformity of the coating to be well controlled.

When a quantity of the coated product is required to be removed from the take-up roll 13, the evaporation of material 36 is stopped by the introduction of inert gas through nozzle 46 until the evaporation pressure ofthe material is exceeded in the retort 37. The pressure in compartment 11 can then be increased to atmospheric and the coated product removed. The compartment 11 and retort 37 can then be re-evacuated and the coating process re-started.

If access to the crucible 35 or the heating element 43 is required sufficient inert gas to cool the retort 37 and its contents is introduced through the nozzle 46. The cooling efficiency may be increased by introducing the inert gas under conditions of turbulent flow and by recirculating the inert gas through refrigerating means (not shown). In order to minimise the stoppage time the cooling time can be shortened by constructing the retort 37, crucible 35, heating element 43 and shielding 38 with materials having low heat capacity. For this reason the shielding may advantageously comprise refractory metal and the heating element may be constructed of stainless steel.

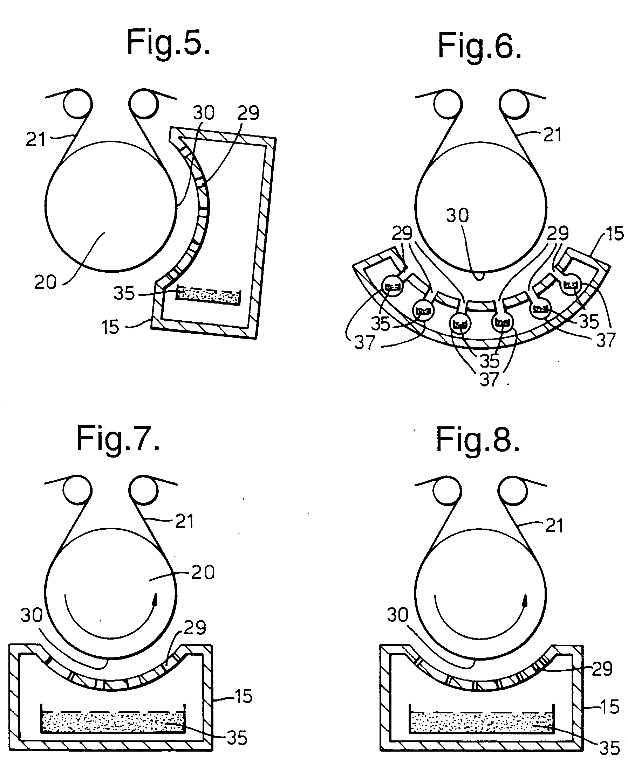

In Fig. 5 the evaporation 15 has an arcuate array of nozzles similar to that of Fig 4 and is located at one side of the chilled drum 20, so that the vapour from the nozzles 29 is directed in a generally horizontal direction against the web substrate 21 in the deposition zone 30. One or more evaporators 15 may be orientated around the drum 20, effectively enlarging the deposition zone.

In the apparatus modification shown in Fig. 6, the evaporator 15 contains 6 retorts 37 each containing a crucible 35 containing material to be vaporised and having a single nozzle 29, the nozzles being disposed sequentially and terminating on an arc around the deposition zone 30. The crucibles 35 are heated by a common heating means; they need not contain identical materials.

In the apparatus modification of Fig. 7 the evaporator 15 is similar to that shown in Figs 4 and 5 but the width of the sequence of nozzles 29 is progressively increased. This is advantageous for the application of heavy coatings which add to the thermal mass of the web. As the coating is progressively built-up the web is able to withstand more heat load for a given temperature rise so that more material may be deposited, in this case by a progressive widening of the nozzles.

In the apparatus modification shown in Fig. 8 the evaporation 15 is similar to that shown in Fig. 7 but the width of the nozzles 29 remains constant and the nozzle spacing is progressively reduced, thereby giving the same advantage for heavy coating as the modification of Fig. 7.

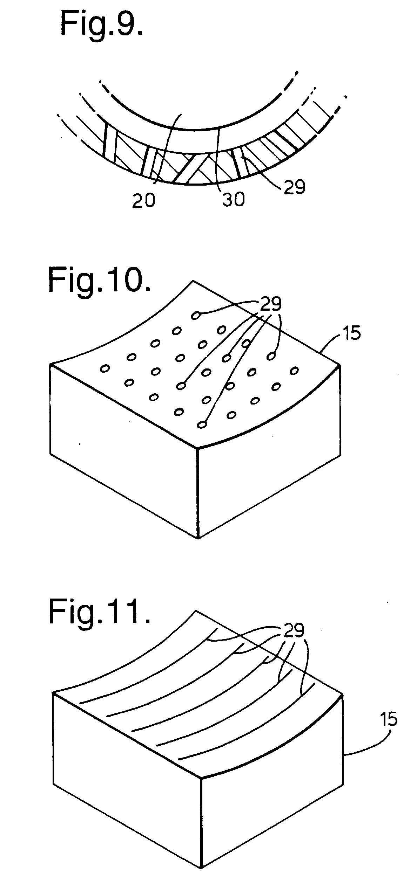

The modification shown in Fig. 9 illustrates how the nozzle direction can be varied to control the direction in which the vapour impinges on the web substrate. In some cases this may affect the properties of the coating. The nozzle direction may also be varied to prevent unvaporised particles travelling directly from the surface of material in the crucible 35 to the web substrate at the deposition zone 30 and adversely affecting the quality of the coating.

The nozzle array shown in Fig. 10 consists of lines of spaced nozzles 29 of circular cross-section arranged in a sequence of lines lying transverse to the direction of the web substrate advance, the nozzle outlets lying on an arcuate surface.

The nozzle array shown in Fig. 11 consists of a sequence of slots orientated in the direction of the web substrate advance with the nozzle outlets on an arcuate surface and the slots being in sequence transverse to the direction of the web substrate advance.

The practice of the invention is further illustrated by the following Example.

### Example

A 25µm (micron) thick web of capacitor grade paper commercially available from M H Dielectrics, Mount Holly Springs, Pa, USA, was fed at a rate of 2.5 metres/minute over a chilled roll having a radius of 30cms, rotating in a vacuum chamber at a pressure of 8 x 10⁻² pascals (8 x 10⁻⁴ millibars).
Zinc vapour, evaporated from 6 retorts arranged as shown in Fig 6, flowed through 6 elongated nozzles (29) each 38mm wide and extending over the width ofthe chilled roll (20), the nozzle exits being disposed at 15cm spacing on an arcuate surface having a diameter of 45cm.

The temperature of the retorts was 630°C and a 3.0µm (micron) thick coating of zinc was deposited on the paper, the variation of the coating being ± 5% by weight over the area of the web.

The coating process could be commenced 22 minutes after the start of heating the evaporator and evacuating the vacuum chamber. Evaporation of the zinc could be stopped instantaneously by feeding argon gas at a pressure of 7 x 10⁴ - 9 x 10⁴ pascals (700 - 900 millibars) around the nozzle exits. By circulating argon gas around the retorts the evaporator could be cooled in 40 minutes to a temperature at which the uncoated paper supply and the zinc in the retorts could safely be replenished.

## Claims

1. An evaporator for vacuum web coating comprising an evaporation means(15,32) for vaporising coating material(36) to be deposited on a web substrate(21), said evaporation means having vapour outlet means(29) comprising at least one outlet nozzle through which vapour can be conveyed and deposited on a web substrate(21) at a deposition zone(30), characterised by having supply means(15) whereby when the process must be stopped inert gas is fed to the evaporation means to quench the evaporation ofthe material(36) from the evaporation means and optionally to cool the evaporation means.

2. An evaporator as claimed in claim 1 characterised in that the evaporation means(15) comprises at least one retort(37) each retort having at least one vapour outlet nozzle(29) and being sealed except for the vapour outlet nozzle or nozzles, said retort(37), in operation, containing the coating material(36) to be vaporised.

3. An evaporator as claimed in claim 2 characterised in that the retort(37) has low thermal capacity.

4. Apparatus for vacuum web coating comprising a vacuum chamber containing at least one deposition zone(30); web holding means(10,13,24,25) for maintaining a web substrate(21) in said deposition zone; and evaporation means(15,32) for vaporising material to be deposited on the web substrate, said evaporation means(15,32) having vapour outlet means(2) comprising at least one outlet nozzle through which vapour is conveyed and deposited on the said web substrate(21) at the said
deposition zone(30); characterised in that the said apparatus further comprises supply means(45,46) whereby when the process must be stopped inert gas is fed to the evaporation means to quench the evaporation of material therefrom and optionally, to cool the evaporation means.

5. Apparatus as claimed in claim 4 wherein the gas supply means(45,46) comprises one or more gas conveying conduits(46) leading into the vacuum chamber(12) from a source of inert gas.

6. Apparatus as claimed in claim 5 wherein a gas conveying conduit is arranged to convey gas to a portion ofthe vacuum chamber which is in communication with the vapour outlet means(29) whereby quenching gas may be back-fed through the vapour outlet means to the coating material(36) in the evaporation means.

7. Apparatus as claimed in claim 5 or claim 6 wherein at least one gas conveying conduit(46) is arranged to feed gas directly from the gas source to the coating material(36) in the evaporation means.

8. Apparatus as claimed in any one of claims 5 to 7 wherein the web holding means(10,13,24,25) comprises a web transport system(10,13,24,25) for continuously advancing a web substrate(21) through the deposition zone(30).

9. A process of vacuum web coating which comprises maintaining a web substrate(21) in a chilled deposition zone(30);
vaporizing a material(36) to be deposited on the substrate;
conveying the generated vapour to the surface of the substrate(21) at the said deposition zone(30); and condensing the vapour as a coating on the substrate; characterised in that when the process must be stopped the evaporation of material(36) is quenched by introducing inert gas around the material being vaporised at a pressure higher than the evaporation vapour pressure of the material.

10. A process as claimed in claim 9 characterised in that sufficient inert gas is introduced to cool any residual unvaporised material(36) and any apparatus(35,37,43) for heating or containing the material.

11. A process as claimed in claim 9 or claim 10 characterised in that the inert gas is introduced under conditions ofturbulent flow.

## Patentansprüche

1. Verdampfer zum Vakuumbeschichten einer Bahn, mit einer Verdampfungseinrichtung (15, 32) zum Verdampfen von auf einem Bahnsubstrat (21) abzulagerndem Beschichtungsmaterial (36), wobei die Verdampfungseinrichtung eine Dampfauslaßeinrichtung (29) hat, die zumindest eine Auslaßdüse aufweist, durch welche Dampf geführt werden kann und in einer Ablagerungszone (30) an einem Bahnsubstrat (21) abgelagert werden kann, gekennzeichnet durch eine Zufuhreinrichtung (15), wodurch, wenn der Prozeß gestoppt werden muß, Inertgas zu der Verdampfunqseinrichtung gespeist wird, um die Verdampfung des Materials (36) von der Verdampfungseinrichtung zu unterbrechen und gegebenenfalls die Verdampfungseinrichtung zu kühlen.

2. Verdampfer nach Anspruch 1, dadurch gekennzeichnet, daß die Verdampfungseinrichtung (15) zumindest einen Kolben (37) hat, wobei jeder Kolben zumindest eine Dampfauslaßdüse (29) hat und bis auf die Dampfauslaßdüse oder -düsen abgedichtet ist, wobei der Kolben (37) im Betrieb das zu verdampfende Beschichtungsmaterial (36) enthält.

3. Verdampfer nach Anspruch 2, dadurch gekennzeichnet, daß der Kolben (37) eine geringe Wärmekapazität hat.

4. Vorrichtung zum Vakuumbeschichten einer Bahn, mit einer Vakuumkammer, die zumindest eine Ablagerungszone (30) enthält, einer Bahnhalteeinrichtung (10, 13, 24, 25) zum Halten eines Bahnsubstrats (21) in der Ablagerungszone; und einer Verdampfungseinrichtung (15, 32) zum Verdampfen von auf dem Bahnsubstrat abzulagerndem Material, wobei die Verdampfungseinrichtung (15, 32) eine Dampfauslaßeinrichtung (2) hat, die zumindest eine Auslaßdüse aufweist, durch welche Dampf geführt wird und in der Ablagerungszone (30) auf dem Bahnsubstrat (21) abgelagert wird; dadurch gekennzeichnet, daß die Vorrichtung ferner eine Zufuhreinrichtung (45, 46) aufweist, wodurch, wenn der Prozeß gestoppt werden muß, Inertgas zu der Verdampfungseinrichtung gespeist wird, um die davon ausgehende Verdampfung von Material zu unterbrechen und gegebenenfalls die Verdampfungseinrichtung zu kühlen.

5. Vorrichtung nach Anspruch 4, wobei die Gaszufuhreinrichtung (45, 46) einen oder mehrere Gasführungskanäle (46) aufweist, die von einer Inertgasquelle in die Vakuumkammer (12) gehen.

6. Vorrichtung nach Anspruch 5, wobei ein Gasführungskanal eingerichtet ist, um Gas zu einem Abschnitt der Vakuumkammer zu führen, der mit der Dampfauslaßeinrichtung (29) in Verbindung steht, so daß Unterbrechungsgas durch die Dampfauslaßeinrichtung zu dem Beschichtungsmaterial (36) in der Verdampfungseinrichtung rückgespeist wird.

7. Vorrichtung nach Anspruch 5 oder Anspruch 6, wobei zumindest ein Gasführungskanal (46) eingerichtet ist, um Gas unmittelbar von der Gasquelle zu dem Beschichtungsmaterial (36) in der Verdampfungseinrichtung zu führen.

8. Vorrichtung nach einem der Ansprüche 5 bis 7, wobei die Bahnhalteeinrichtung (10, 13, 24, 25) ein Bahnfördersystem (10, 13, 24, 25) zum fortlaufenden Vorrücken eines Bahnsubstrats (21) durch die Ablagerungszone (30) hat.

9. Verfahren zum Vakuumbeschichten einer Bahn, das ein Halten eines Bahnsubstrats (21) in einer abgekühlten Ablagerungszone (30);
ein Verdampfen eines auf dem Substrat abzulagernden Materials (36);
ein Führen des erzeugten Dampfes zu der Oberfläche des Substrats (21) in der Ablagerungszone (30); und
ein Kondensieren des Dampfs als eine Beschichtung auf dem Substrat einschließt; dadurch gekennzeichnet, daß, wenn der Prozeß gestoppt werden muß, das Verdampfen von Material (36) dadurch unterbrochen wird, daß Inertgas um das verdampfende Material eingeführt wird, und zwar bei einem Druck, der größer ist als der Verdampfungsdampfdruck des Materials.

10. Verfahren nach Anspruch 9, dadurch gekennzeichnet, daß ausreichend Inertgas eingeführt wird, um jegliches verbleibende nicht verdampfte Material (36) und jegliche Vorrichtung (35, 37, 43) zum Heizen oder Unterbringen des Materials zu kühlen.

11. Verfahren nach Anspruch 9 oder Anspruch 10, dadurch gekennzeichnet, daß das Inertgas in Zuständen turbulenter Strömung eingeführt wird.

## Revendications

1. Evaporateur pour le revêtement sous vide d'une bande, comportant des moyens d'évaporation (15, 32) destinés à vaporiser une matière de revêtement (36) devant être déposée sur un substrat en bande (21), lesdits moyens d'évaporation ayant un moyen (29) de sortie de vapeur comportant au moins un ajutage de sortie à travers lequel une vapeur peut être transportée et déposée sur un substrat en bande (21) dans une zone de dépôt (30), caractérisé par le fait qu'il comporte des moyens d'alimentation (15) par lesquels, lorsque le processus doit être arrêté, un gaz inerte est amené aux moyens d'évaporation pour couper l'évaporation de la matière (36) à partir des moyens d'évaporation et, optionnellement, refroidir les moyens d'évaporation.

2. Evaporateur selon la revendication 1, caractérisé en ce que les moyens d'évaporation (15) comprennent au moins une moufle (37), chaque moufle ayant au moins un ajutage (29) de sortie de vapeur et étant fermée de façon étanche à l'exception de l'ajutage ou des ajutages de sortie de vapeur, ladite moufle (37), en fonctionnement, contenant la matière de revêtement (36) devant être vaporisée.

3. Evaporateur selon la revendication 2, caractérisé en ce que la moufle (37) possède une faible capacité thermique.

4. Appareil pour le revêtement sous vide d'une bande, comportant une chambre à vide contenant au moins une zone (30) de dépôt ; des moyens (10, 13, 24, 25) de maintien de bande destinés à maintenir un substrat en bande (21) dans ladite zone de dépôt ; et des moyens d'évaporation (15, 32) destinés à vaporiser une matière devant être déposée sur le substrat en bande, lesdits moyens d'évaporation (15, 32) ayant un moyen (2) de sortie de vapeur comprenant au moins un ajutage de sortie à travers lequel une vapeur est transportée et déposée sur ledit substrat en bande (21) dans ladite zone (30) de dépôt ; caractérisé en ce que ledit appareil comporte en outre des moyens d'alimentation (45, 46) par lesquels, lorsque le processus doit être arrêté, un gaz inerte est amené aux moyens d'évaporation pour couper l'évaporation de la matière à partir de ces moyens et, optionnellement, pour refroidir les moyens d'évaporation.

5. Appareil selon la revendication 4, dans lequel les moyens (45, 46) d'alimentation en gaz comprennent un ou plusieurs conduits (46) de transport de gaz menant depuis une source de gaz inerte jusque dans la chambre à vide (12).

6. Appareil selon la revendication 5, dans lequel un conduit de transport de gaz est agencé de façon à transporter du gaz jusqu'à une partie de la chambre à vide qui est en communication avec le moyen (29) de sortie de vapeur, grâce à quoi un gaz de coupage peut être renvoyé à travers les moyens de sortie de vapeur à la matière de revêtement (36) dans les moyens d'évaporation.

7. Appareil selon la revendication 5 ou 6, dans lequel au moins un conduit (46) de transport de gaz est agencé de façon à amener du gaz directement de la source de gaz à la matière de revêtement (36) dans les moyens d'évaporation.

8. Appareil selon l'une quelconque des revendications 5 à 7, dans lequel les moyens (10, 13, 24, 25) de maintien de bande comprennent un système (10, 13, 24, 25) de transport de bande destiné à faire avancer en continu un substrat en bande (21) à travers la zone de dépôt (30).

9. Procédé de revêtement sous vide d'une bande qui comprend le maintien d'un substrat en bande (21) dans une zone de dépôt refroidie (30) ;
la vaporisation d'une matière (36) devant être déposée sur le substrat ;
le transport de la vapeur générée vers la surface du substrat (21) dans ladite zone de dépôt (30) ; et la condensation de la vapeur en tant que revêtement sur le substrat ; caractérisé en ce que, lorsque le processus doit être arrêté, l'évaporation de la matière (36) est coupée par l'introduction d'un gaz inerte autour de la matière en cours de vaporisation, sous une pression plus élevée que la pression de vapeur d'évaporation de la matière.

10. Procédé selon la revendication 9, caractérisé en ce qu'un gaz inerte suffisant est introduit pour refroidir toute matière non vaporisée résiduelle (36) et tout appareil (35, 37, 43) destiné à chauffer ou contenir la matière.

11. Procédé selon la revendication 9, ou la revendication 10, caractérisé en ce que le gaz inerte est introduit dans des conditions d'écoulement turbulent.
